# EUROPEAN PATENT APPLICATION

(11) **EP 2 360 731 A2**
(43) Date of publication of application: **24.08.2011**
(21) Application number: 11155251.9
(22) Date of filing: 21.02.2011
(51) Int. Cl.: H01L 31/0224, H01L 31/18

(54) **Photovoltaic cell substrate and photovoltaic cell including the same**

(30) Priority: 19.02.2010 KR 20100015152
(71) Applicant: Samsung Corning Precision Materials Co., Ltd., Gyeongsangbuk-do 730-735 (KR)
(72) Inventor: Ryoo, Je Choon, 336-841, Asan-si (KR); Yoo, Young Zo, 336-841, Asan-si (KR); Kim, Seo Hyun, 336-841, Asan-si (KR); Kim, Jin Seok, 336-841, Asan-si (KR)
(74) Representative: Gulde Hengelhaupt Ziebig & Schneider

(57) **Abstract**

A photovoltaic cell substrate includes a transparent substrate and a zinc oxide thin film layer doped with a dopant. The zinc oxide thin film layer is formed over the transparent substrate. The zinc oxide thin film layer has a (0002) crystal plane and a (101̅1) crystal plane which accounts for 3% or more of the (0002) crystal plane according to X-Ray Diffraction (XRD) data.

## Description

### CROSS REFERENCE TO RELATED APPLICATION

The present application claims priority from Korean Patent Application Number 10-2010-0015152 filed on February 19, 2010, the entire contents of which application are incorporated herein for all purposes by this reference.

### BACKGROUND OF THE INVENTION

### Field of the Invention

The present invention relates to a photovoltaic cell substrate and a photovoltaic cell including the same.

### Description of Related Art

A photovoltaic cell is a key element in the solar power generation, in which energy from sunlight is converted directly into electricity. Photovoltaic cells are applied in various fields, including electrical and electronic appliances, the supply of electrical power to houses and buildings, and industrial power generation. The most basic structure of the photovoltaic cell is a p-n junction diode. Photovoltaic cells are classified, according to the material that is used in the light absorbing layer, into: a silicon photovoltaic cell, which uses silicon as the light absorbing layer; a compound photovoltaic cell, which uses Copper Indium Diselenide (CIS: CuInSe₂), Cadmium Telluride (CdTe), etc. as the light absorbing layer; a dye-sensitized photovoltaic cell, in which photosensitive dye particles, which activate electrons by absorbing visible light, are adsorbed on the surface of nanoparticles of a porous film; a tandem photovoltaic cell. In addition, photovoltaic cells can be classified into bulk photovoltaic cells and thin film photovoltaic cells.

At present, bulk polycrystalline silicon photovoltaic cells occupy 90% or more of the market. However, power generation using bulk polycrystalline silicon photovoltaic cells is three to ten times as expensive as existing power generation such as thermal power generation, nuclear power generation, or hydraulic power generation. This is mainly attributable to expensive polycrystalline silicon and the high manufacturing cost of bulk polycrystalline silicon photovoltaic cells, which is complicated to manufacture. Therefore, in recent days, thin-film amorphous silicon (a-Si:H) photovoltaic cells and thin-film microcrystalline silicon (µc-Si : H) photovoltaic cells are being actively studied and commercially distributed.

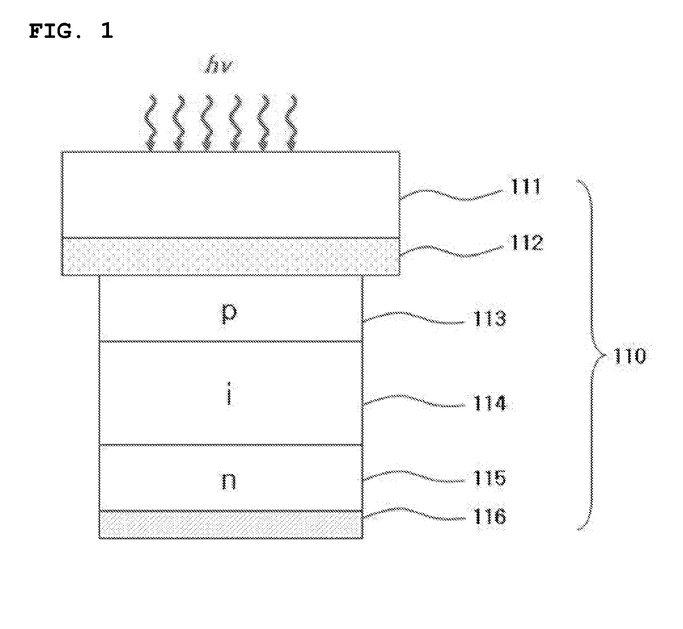

FIG. 1 is a cross-sectional view showing the structure of a photovoltaic cell 110 of the related art which uses amorphous silicon as a light-absorbing layer.

As shown in FIG. 1, the conventional amorphous silicon (e.g., a-Si:H) photovoltaic cell 110 includes a transparent substrate 111, a transparent conductive film 112, a p-type amorphous silicon (a-Si:H) layer 113, which is doped with a dopant, an intrinsic amorphous silicon (a-Si:H) layer 114, which is not doped with a dopant, an n-type amorphous silicon (a-Si:H) layer 115, which is doped with a dopant, and a back reflector 116. In this p-i-n type amorphous silicon (a-Si:H) structure, the intrinsic amorphous silicon (a-Si:H) layer 114 is subject to depletion by the p-type and n-type amorphous silicon (a-Si:H) layers 113 and 115 such that an electric field is created therein. When an electron-hole pair is formed in the intrinsic amorphous silicon (a-Si:H) layer 114 in response to incident light (hv), it drifts due to the internal electrical field and is then collected by the p-type amorphous silicon (a-Si:H) layer 113 and the n-type amorphous silicon (a-Si:H) layer 115, thereby generating electrical current.

Microcrystalline silicon (µc-Si:H) is an intermediate between single crystalline silicon and amorphous silicon, and has a grain size ranging from tens to hundreds of nanometers. At the grain boundary, an amorphous phase is frequently present and, in most cases, carrier recombination occurs due to its high density of defects. Microcrystalline silicon (µc-Si : H) has an energy band gap of about 1.6eV, which is not significantly different from that of single crystalline silicon (about 1.12Ev), and does not exhibit such deterioration as occurs in the amorphous silicon (a-Si:H) photovoltaic cell. The structure of the microcrystalline silicon (µc-Si:H) photovoltaic cell is very similar to that of the amorphous silicon (a-Si:H) photovoltaic cell, except for the light absorbing layer.

A single p-i-n junction thin film photovoltaic cell which uses amorphous silicon (a-Si:H), microcrystalline silicon (µc-Si:H), etc. as the light absorbing layer, has low light conversion efficiency, which imposes many restrictions on its practical use. Therefore, a tandem (multi-junction) photovoltaic cell is introduced, which is fabricated by multi-stacking the amorphous silicon (a-Si:H) photovoltaic cell units, the microcrystalline silicon (µc-Si:H) photovoltaic cell units, etc. The tandem photovoltaic cell has such structure that the photovoltaic cell units are connected in series and thereby can increase open circuit voltage and improve the light conversion efficiency.

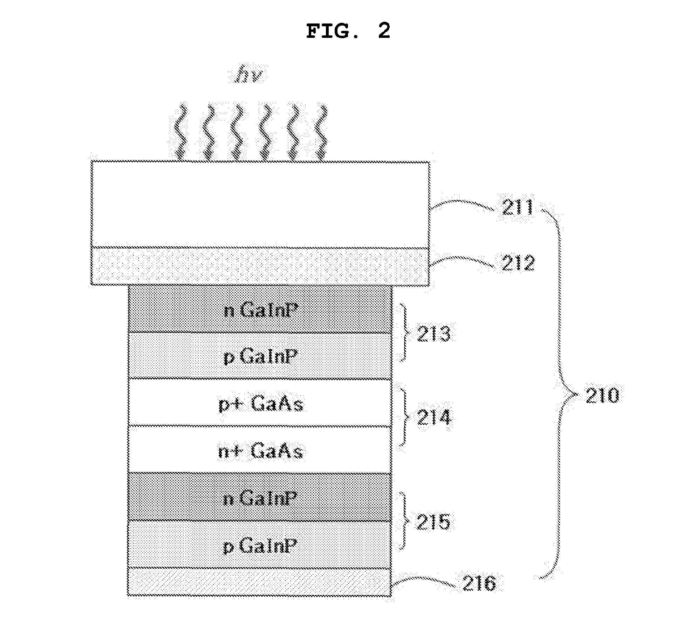

FIG. 2 is a cross-sectional view showing the structure of a tandem photovoltaic cell 210 of the related art.

As shown in FIG. 2, the tandem photovoltaic cell 210 of the related art generally includes a transparent substrate 211, a transparent conductive film 212, a first p-n junction layer 213, a tunneling p-n junction layer 214, a second p-n junction layer 215, and a back reflector 216.

In the tandem photovoltaic cell 210 of the related art, the first p-n junction layer 213, having a predetermined band gap (e.g., E*_{g}*=1.6eV), is disposed above the second p-n junction layer 215, which has a smaller band gap (e.g., E*_{g}*=1.1eV), such that a photon having an energy of 1.1eV**<**h*ν***<**1.6eV is allowed to pass through the first p-n junction layer 213 but is absorbed by the second p-n junction layer 215. It is possible to realize higher light conversion efficiency by increasing the number of p-n junction layers that are stacked in the tandem photovoltaic cell.

The transparent conductive film used in the photovoltaic cell is required to exhibit excellent light transmittance, electrical conductivity, and light trapping efficiency. In particular, in the case of the tandem thin film photovoltaic cell, the transparent conductive film is required to show high light transmittance and a high haze value over a wide wavelength band ranging from 400nm to 1100nm. In addition, while the transparent conductive film is deposited, it is also required to withstand hydrogen plasma.

The popular transparent conductive film for photovoltaic cell applications contains tin oxide (SnO2) as a main ingredient. However, this type of transparent conductive film suffers from deterioration due to hydrogen plasma and is thereby blackened when it is deposited through Plasma Enhanced Chemical Vapor Deposition (PECVD), which results in the decrease in the transmittance thereof. In addition, Indium Tin Oxide (ITO), which is generally used for existing transparent conductive films, has problems related to the continuously rising price of the main ingredient, indium (In), which is a rare element, the high reducibility of indium during the hydrogen plasma process and resultant chemical instability, and the like.

Therefore, studies are underway toward the development of a transparent conductive film that can replace the transparent film having SnO2 or ITO as its main ingredient. Zinc oxide (ZnO) is the material that is recently gaining attention as the most ideal material. Since zinc oxide can be easily doped and has a narrow conductivity band, it is easy to control the electrical-optical properties of zinc oxide depending on the type of dopant. In addition, the transparent conductive film having zinc oxide as a main ingredient is stable when subjected to the hydrogen plasma process, can be fabricated at low cost, and exhibits high light transmittance and high electrical conductivity.

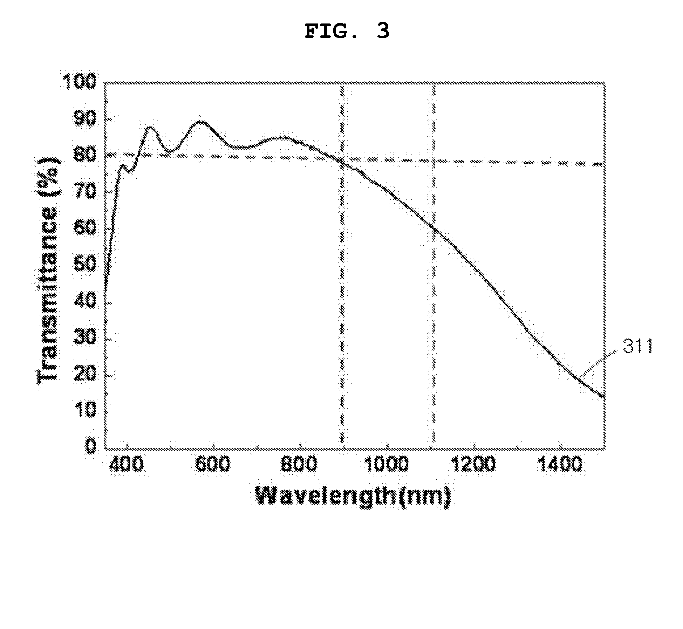

FIG. 3 is a graph showing the light transmittance of a Ga-doped zinc oxide thin film 311 depending on wavelength.

As shown in FIG. 3, the light transmittance of the Ga-doped zinc oxide thin film 311 sharply drops to or below 80% in the wavelength range from 900nm to 1100nm. As such, zinc oxide (ZnO) exhibits low light transmittance in a long wavelength range (of 900nm or more) depending on the dopant that is added thereto. Thus, zinc oxide has a problem in that its photoelectric conversion efficiency decreases especially when it is applied to a Tandem type thin film photovoltaic cell.

The information disclosed in this Background of the Invention section is only for the enhancement of understanding of the background of the invention, and should not be taken as an acknowledgment or any form of suggestion that this information forms a prior art that would already be known to a person skilled in the art.

### BRIEF SUMMARY OF THE INVENTION

Various aspects of the present invention provide a photovoltaic cell substrate that can be used in a photovoltaic cell and has excellent light transmittance in a long wavelength range, and a photovoltaic cell including the same photovoltaic cell substrate.

Also provided is a photovoltaic cell substrate having high photoelectric conversion efficiency and a photovoltaic cell including the same photovoltaic cell substrate.

In an aspect of the present invention, the photovoltaic cell substrate includes a transparent substrate and a zinc oxide (ZnO) film doped with a dopant, the zinc oxide thin film layer formed over the transparent substrate. In the zinc oxide thin film layer, a **(1011)** crystal plane is 3% or more of a (0002) crystal plane according to X-Ray Diffraction (XRD) data. In other words, both, a **(1011)** crystal plane and a (0002) crystal plane are present in the zinc oxide thin film layer according to X-Ray Diffraction (XRD) data.

In the sense of the present invention, the presence of a (0002) growth plane and a **(1011)** growth plane is understood in that the intensity of the X-Ray Diffraction (XRD) data signal of each of the (0002) growth plane and the **(1011)** growth plane is significantly (preferably two times, more preferably ten times) higher than the average intensity of the signal noise.

Preferably the zinc oxide thin film layer contains the dopant added to zinc oxide in an amount of 0.1wt% to 15wt%, and has a thickness ranging from 450nm to 900nm.

Preferably the dopant added to zinc oxide is one selected from among Al, Ga, In, Ti, and B, or two or more thereof.

Preferably the photovoltaic cell substrate further comprises an impurity material elution-preventing film formed between the transparent substrate and the zinc oxide thin film layer, the impurity material elution-preventing film preventing impurity material from being eluted from inside the transparent substrate.

Preferably the impurity material elution-preventing film is made of silicon oxide (SiO₂) or titanium oxide (TiO₂) .

In an aspect of the present invention, a photovoltaic cell comprises a photovoltaic cell substrate, wherein the photovoltaic cell substrate comprises: a transparent substrate; and a zinc oxide thin film layer doped with a dopant, wherein the zinc oxide thin film layer is formed over the transparent substrate, and has a (0002) crystal plane and a **(1011)** crystal plane which accounts for 3% or more of the (0002) crystal plane according to X-Ray Diffraction (XRD) data.

Preferably the photovoltaic cell is a photovoltaic cell selected from among a tandem photovoltaic cell, a compound photovoltaic cell, and a dye-sensitized photovoltaic cell.

As set forth above, although light absorption occurring in a long wavelength range due to resonance between dopant and zinc atoms and between dopant and oxygen atoms decreases transmittance when a dopant is added to the inside of the zinc oxide thin film layer affluent of the (0002) crystal planes, the presence of the **(1011)** crystal plane decreases the resonance between the dopant and zinc atoms and between the dopant and oxygen atoms. Accordingly, the photovoltaic cell substrate has an advantage in that it exhibits light transmittance of 80% or more in a wavelength range from 900nm to 1100nm.

The methods and apparatuses of the present invention have other features and advantages which will be apparent from, or are set forth in more detail in the accompanying drawings, which are incorporated herein, and in the following Detailed Description of the Invention, which together serve to explain certain principles of the present invention.

### BRIEF DESCRIPTION OF THE DRAWINGS

FIG. 1 is a cross-sectional view showing the structure of a photovoltaic cell of the related art which uses amorphous silicon as a light-absorbing layer;

FIG. 2 is a cross-sectional view showing the structure of a tandem photovoltaic cell of the related art;

FIG. 3 is a graph showing the light transmittance of a Ga-doped zinc oxide thin film depending on wavelength;

FIG. 4 is a flowchart showing a method of fabricating a photovoltaic cell substrate according to an exemplary embodiment of the invention;

FIG. 5 is a cross-sectional view showing the structure of a photovoltaic cell substrate according to an exemplary embodiment of the invention;

FIG. 6 is graphs showing the X-Ray Diffraction (XRD) patterns of a photovoltaic cell substrate according to an exemplary embodiment of the invention before and after heat treatment; and

FIG. 7 is a graph showing the light transmittance of a zinc oxide thin film layer doped with a dopant, which is used in a photovoltaic cell substrate according to an exemplary embodiment of the invention, depending on wavelength before and after heat treatment.

### DETAILED DESCRIPTION OF THE INVENTION

Reference will now be made in detail to various embodiments of the present invention, examples of which are illustrated in the accompanying drawings and described below. While the invention will be described in conjunction with exemplary embodiments, it is to be understood that the present description is not intended to limit the invention to those exemplary embodiments. On the contrary, the invention is intended to cover not only the exemplary embodiments, but also various alternatives, modifications, equivalents and other embodiments that may be included within the scope of the invention as defined by the appended claims.

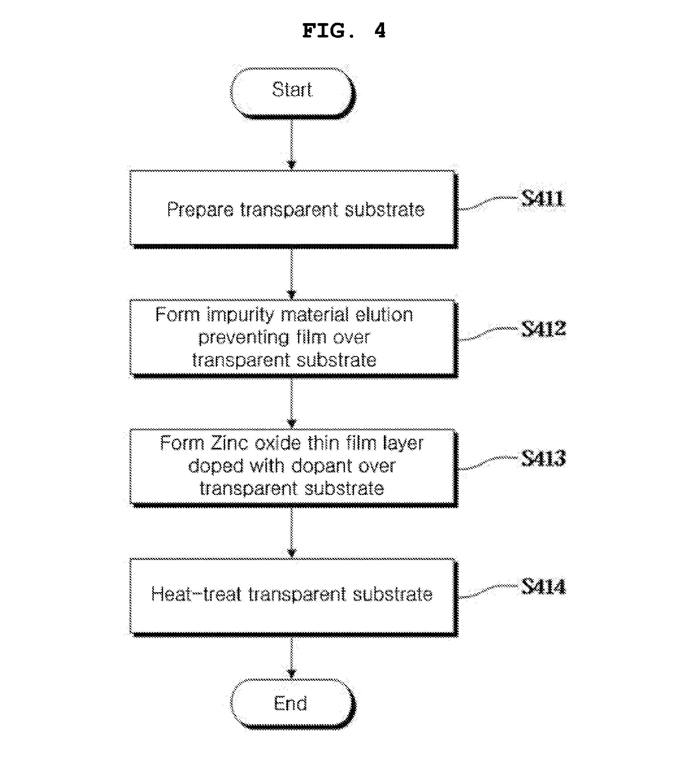

FIG. 4 is a flowchart showing a method of fabricating a photovoltaic cell substrate according to an exemplary embodiment of the invention.

AS shown in FIG. 4, in the method of fabricating a photovoltaic cell substrate, a transparent substrate is prepared at step S411. In an example, the transparent substrate can be placed inside a sputtering chamber, in which a sputtering target made of the material to be deposited is mounted.

Afterwards, an impurity material elution-preventing film is formed over the transparent substrate at S412. The impurity material elution-preventing film serves to prevent impurity material from being eluted from the inside of the transparent substrate. In an example, the impurity material elution-preventing film can be made of silicon oxide (SiO₂) or titanium oxide (TiO₂) .

Afterwards, at S413, a zinc oxide (ZnO) thin film layer doped with a dopant is formed over the transparent substrate, such that a **(1011)** crystal plane accounts for 3% or more of a (0002) crystal plane (that is, the intensity of the **(1011)** crystal plane is 3% or more of the intensity of the (0002) crystal plane) according to X-Ray Diffraction (XRD) data. In an example, the dopant added to zinc oxide can be one or two or more selected from among aluminum (Al), gallium (Ga), indium (In), titanium (Ti), and boron (B).

In order for the **(1011)** crystal plane to be 3% or more of the (0002) crystal plane according to the XRD data, for example, the pressure inside the sputtering chamber is maintained in the range from 1mTorr to 50mTorr and the temperature of the transparent substrate is preferably maintained in the range from 200°C to 300°C.

In S414, the transparent substrate having the zinc oxide thin film layer formed thereover is heated at a temperature below its transition temperature for 1 to 30 minutes. It is preferred that the temperature range, for example, from 250°C to 500°C. Heat treatment may be implemented, for example, by Rapid Thermal Annealing (RTA) or laser irradiation. In addition, the heat treatment may be carried out in an inert gas atmosphere containing nitrogen, helium, argon, or the like.

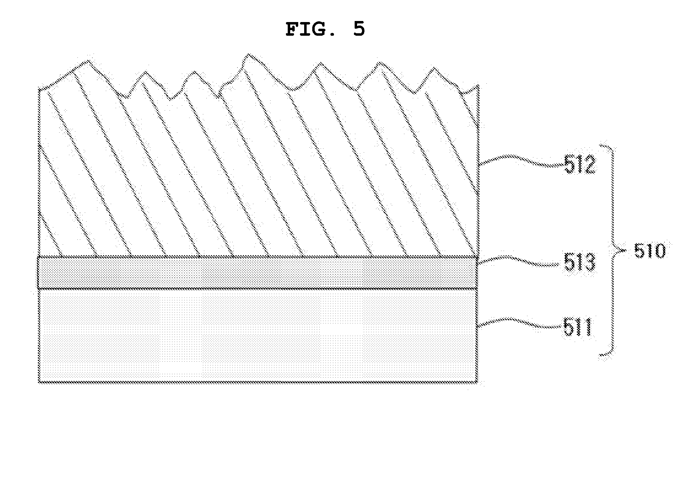

FIG. 5 is a cross-sectional view showing the structure of a photovoltaic cell substrate according to an exemplary embodiment of the invention.

As shown in FIG. 5, the photovoltaic cell substrate 510 includes a zinc oxide (ZnO) thin film layer 512 doped with a dopant.

The transparent substrate 511 can be a sheet of glass, which supports the thin film photovoltaic cell. This transparent substrate 511 of glass may have a thickness of 5mm or less and a light transmittance of 90% or more. In another example, the transparent substrate 511 can be a heat curing or Ultraviolet (UV) curing organic film, which is generally made of a polymer-based material. Examples of the polymer-based material may include Polyethylene Terephthalate (PET), acryl, Polycarbonate (PC), Urethane Acrylate (UA), polyester, Epoxy Acrylate (EA), brominate acrylate, Polyvinyl Chloride (PVC), and the like.

The zinc oxide thin film layer 512 allows an electrical current, generated by photoelectric conversion, to pass therethrough, and may be made of a metal material that has high conductivity and light transmittance. In general, the zinc oxide thin film layer 512 has good photoelectric conversion efficiency when the sheet resistance thereof is 15 Ω/□ or less. The sheet resistance of the zinc oxide thin film layer 512 is dependent on the thickness thereof, as presented in Table 1 below.

**Table 1**

| | | | |
|---|---|---|---|
| Film thickness (nm) | 450 | 700 | 900 |
| Sheet resistance (Ω/□) | 14 | 9 | 7 |

As can be seen in Table 1, the sheet resistance of the zinc oxide thin film layer 512 becomes 15 Ω/□ or less if the thickness thereof is 450nm or more. However, if the zinc oxide thin film layer 512 has a film thickness of 900nm or more, its light transmittance decreases, thereby decreasing the photoelectric conversion efficiency of the photovoltaic cell, although its sheet resistance decreases. This also leads to an increase in the cost of the conductive film.

Since the zinc oxide thin film layer 512 can be easily doped and has a narrow conduction band, its electrical conductivity and optical properties can be easily controlled depending on the dopant. Since the electrical properties of zinc oxide are very similar to those of insulators, it needs to be doped with a dopant in order to have electrical conductivity. However, if zinc oxide contains 15wt% of dopant or more, its crystallinity decreases, thereby decreasing the size of grains of the zinc oxide thin film layer 512. For these reasons, the zinc oxide thin film layer 512 contains, by weight, 0.1% to 15% of dopant added to zinc oxide. Preferably, 0.1wt% to 5wt% of dopant can be contained therein. Here, the dopant added to zinc oxide can be one or two or more selected from among aluminum (Al) , gallium (Ga), indium (In), titanium (Ti), and boron (B). In an example, the zinc oxide may be co-doped with two or more dopants. It is preferred that the dopant in zinc oxide be Ga or Al, which exhibits relatively good moisture resistance.

The zinc oxide thin film layer 512 can be formed by one or more selected from among Pulsed Laser Deposition (PLD), Molecular Beam Epitaxy (MBE), Plasma Enhanced Chemical Vapor Deposition (PECVD), Low Pressure Chemical Vapor Deposition (LPCVD), Atmospheric Pressure Chemical Vapor Deposition (APCVD), sputtering, and the like.

As a result of the heat treatment of the zinc oxide thin film layer 512 doped with a dopant, the number of oxygen vacancies and Zn atoms on interstitial sites decreases and dopant atoms on interstitial sites move to Zn lattice sites, which leads to the increase in the concentration of extrinsic donors. That is, the number of interstitial dopant atoms, oxygen vacancies and interstitial Zn atoms, which contribute to free carrier absorption, decreases. Therefore, the photovoltaic cell substrate 510 of this embodiment can improve light transmittance in a long wavelength range through heat treatment.

In an example, the heat treatment may be implemented, for example, by RTA or laser irradiation. In addition, the heat treatment may be carried out in an inert gas atmosphere containing nitrogen, helium, argon, or the like. The heat treatment temperature is below the transition temperature of the transparent substrate 511, and the heating time is in the range from 1 to 30 minutes. It is preferred that the heat treatment temperature be ranges from 250°C to 500°C.

In an additional aspect of the invention, the photovoltaic cell substrate 510 also includes an impurity material elution-preventing film 513.

The impurity material elution-preventing film 513 is formed between the transparent substrate 511 and the zinc oxide thin film layer 512, and serves to prevent impurity material, for example, alkali ions such as sodium ions (Na+) from being eluted from the inside of the transparent substrate 511 made of, for example, soda lime glass (SiO₂-CaO-Na₂O) or aluminosilicate glass (SiO₂-Al₂O-Na₂O) . It is preferred that the impurity material elution-preventing film 513 be made of silicon oxide (SiO₂) or titanium oxide (TiO₂). The refractive index of the impurity material elution-preventing film 513 can be matched with that of the transparent substrate 511 by adjusting the thickness of the film 513. Accordingly, the impurity material elution-preventing film 513 can prevent incident light from being reflected from the surface of the transparent substrate 511. If the transparent substrate 511 is made of borosilicate glass, a transparent conductive film that contains zinc oxide as a main ingredient can be formed directly on the transparent substrate without using an impurity material elution-preventing film.

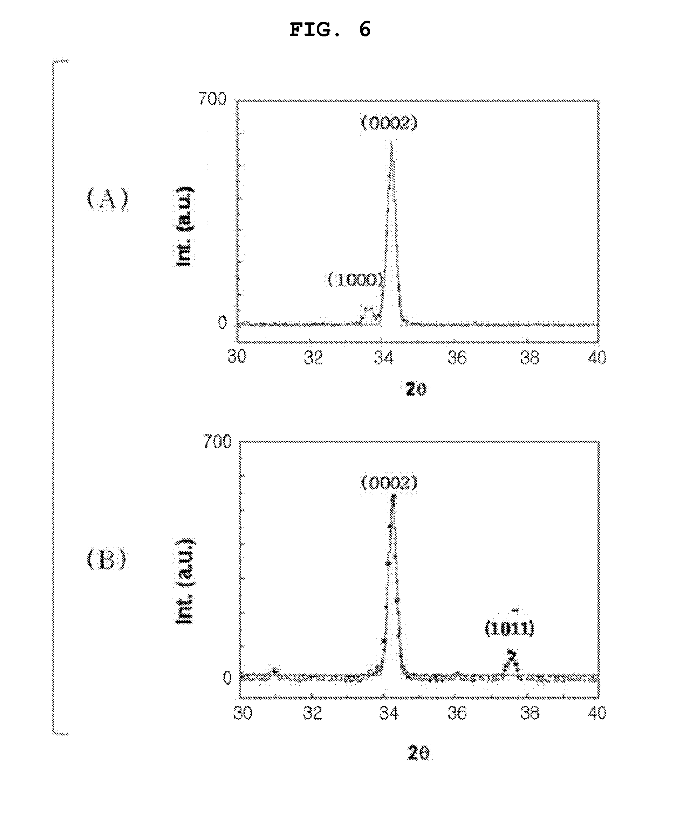

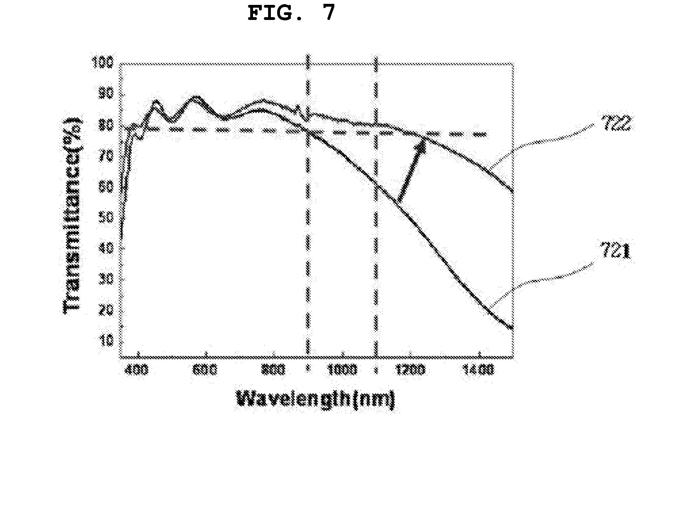

FIG. 6 is graphs showing XRD patterns of a photovoltaic cell substrate according to an exemplary embodiment of the invention, and FIG. 7 is a graph showing the light transmittance versus wavelength of a zinc oxide thin film layer doped with a dopant. Here, the photovoltaic cell substrate of this embodiment includes a Ga-doped zinc oxide thin film layer.

FIG. 6 (A) shows XRD data before the photovoltaic cell substrate including the Ga-doped zinc oxide thin film layer is heat-treated, and FIG. 6 (B) shows XRD data after the photovoltaic cell substrate including the Ga-doped zinc oxide thin film layer is heat-treated.

In FIG. 6 (A), the XRD data of the Ga-doped zinc oxide thin film layer exhibits (0002) peak in the vicinity of 34.2° and (1000) peak in the vicinity of 33.7°. In the meantime, in FIG. 6 (B), the XRD data of the Ga-doped zinc oxide thin film layer exhibits (0002) peak in the vicinity of 34.2° and **(101̅1)** peak in the vicinity of 37.5°.

Referring to FIG. 7, reference numeral 721 is a curve of light transmittance of the Ga-doped zinc oxide thin film layer before heat treatment, and reference numeral 722 is a curve of light transmittance of the Ga-doped zinc oxide thin film layer after heat treatment. Referring to the curve of light transmittance designated by reference numeral 722, it can be appreciated that light transmittance in a wavelength range from 900nm to 1100nm is 80% or more.

The foregoing descriptions of specific exemplary embodiments of the present invention have been presented for the purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the claims appended hereto and their equivalents.

## Claims

1. A photovoltaic cell substrate comprising:
a transparent substrate (511); and
a zinc oxide thin film layer (512) doped with a dopant, wherein the zinc oxide thin film layer (512) is formed over the transparent substrate (511), and wherein a (0002) crystal plane and a **(1011)** crystal plane are present in the zinc oxide thin film layer (512) according to X-Ray Diffraction (XRD) data, wherein the intensity of the X-Ray Diffraction (XRD) data signal of the **(101̅1)** crystal plane is equal to or higher than 3% of the intensity of the X-Ray Diffraction (XRD) data signal of the (0002) crystal plane.

2. The photovoltaic cell substrate of claim 1, wherein the zinc oxide thin film layer (512) contains the dopant added to zinc oxide in an amount of 0.1wt% to 15wt%, and/or wherein the zinc oxide thin film layer (512) has a thickness ranging from 450nm to 900nm.

3. The photovoltaic cell substrate according to any one of the preceding claims, wherein the dopant added to zinc oxide is one selected from among Al, Ga, In, Ti, and B, or two or more thereof.

4. The photovoltaic cell substrate according to any one of the preceding claims, further comprising an impurity material elution-preventing film (513) formed between the transparent substrate (511) and the zinc oxide thin film layer (512), the impurity material elution-preventing film (513) being adapted to prevent impurity material from being eluted from inside the transparent substrate (511).

5. The photovoltaic cell substrate of claim 4, wherein the impurity material elution-preventing film (513) is made of silicon oxide (SiO₂) or titanium oxide (TiO₂).

6. A photovoltaic cell comprising a photovoltaic cell substrate (510) according to any one of the preceding claims.

7. The photovoltaic cell of claim 6, comprising one selected from among a tandem photovoltaic cell, a compound photovoltaic cell, and a dye-sensitized photovoltaic cell.
